# EUROPÄISCHE PATENTANMELDUNG

(11) **EP 1 189 293 A2**
(43) Veröffentlichungstag der Anmeldung: **20.03.2002**
(21) Anmeldenummer: 01117941.3
(22) Anmeldetag: 24.07.2001
(51) Int. Cl.: H01L 41/08, H01L 43/08

(54) **Monolithisch integrierbare Induktivität**

(30) Priorität: 21.08.2000 DE 10040811
(71) Anmelder: Infineon Technologies AG, 81669 München (DE)
(72) Erfinder: Benedix, Alexander, 81739 München (DE); Braun, Georg, 80339 München (DE); Fischer, Helmut, 82024 Taufkirchen (DE); Klehn, Bernd, 81539 München (DE); Kuhne, Sebastian, 01445 Radebeul (DE)
(74) Vertreter: Müller . Hoffmann & Partner Patentanwälte

(57) **Zusammenfassung**

Die Erfindung betrifft eine monolithisch integrierbare Induktivität aus einer Schichtenfolge von leitfähigen Schichten (P1 bis P4) und isolierenden Schichten (I1 bis I3), die einander abwechselnd übereinander gestapelt sind, wobei die leitfähigen Schichten (P1 bis P4) so gestaltet sind, daß sie eine spulenförmige Struktur um einen Mittenbereich (M) bilden, in welchem GMR-Materialien (WM, TB, HM) vorgesehen werden können.

## Beschreibung

Die vorliegende Erfindung betrifft eine monolithisch integrierbare Induktivität, die insbesondere in einer MRAM-Anordnung verwendbar ist.

Obwohl Induktivitäten wichtige Bestandteile elektrischer Schaltungen und in diesen oft unverzichtbar sind, ist bisher noch keine monolithisch integrierbare Induktivität entwickelt worden. Vielmehr werden für integrierte Schaltungen Induktivitäten durch diskrete Bauelemente gebildet, die mit der integrierten Schaltung verbunden sind.

Ein Beispiel einer integrierten Schaltung, in welcher Magnetfelder und damit Induktivitäten benötigt werden, besteht in einer ggf. Auswahltransistoren aufweisenden MRAM-Anordnung. Eine solche hat ein Speicherzellenfeld von matrixartigen angeordneten Speicherzellen, die beispielsweise jeweils aus einem Schichtstapel aus einer hartmagnetischen Schicht, einer Tunnelbarrierenschicht und einer weichmagnetischen Schicht bestehen. Diese Schichtstapel sind an den Kreuzungsstellen zwischen Wortleitungen und senkrecht zu diesen im Abstand verlaufenden Bitleitungen vorgesehen. Die in den Wortleitungen und Bitleitungen fließenden Ströme erzeugen Magnetfelder, welche die Magnetisierungsrichtung der weichmagnetischen Schicht der jeweils selektierten Speicherzelle so zu ändern vermögen, daß diese parallel oder antiparallel zu der Magnetisierungsrichtung der hartmagnetischen Schicht ist. Eine parallele Magnetisierung der weichmagnetischen Schicht zur hartmagnetischen Schicht liefert einen niedrigeren Widerstandswert des Schichtstapels als eine antiparallele Magnetisierung dieser Schichten. Die unterschiedlichen Widerstandswerte des Schichtstapels können dann als Informationseinheit "0" oder "1" interpretiert werden.

Die Wortleitung und die Bitleitung einer selektierten Speicherzelle, die das die Magnetisierungsrichtung der weichmagnetischen Schicht festlegende Magnetfeld erzeugen, sind infolge der fortschreitenden Miniaturisierung von integrierten Schaltkreisen stromführende Leitungen mit minimalen Abmessungen, die so nur für Ströme im mA-Bereich nutzbar sind, welche ein entsprechend schwaches Magnetfeld liefern, so daß eine sichere Bestimmung der Magnetisierungsrichtung in der weichmagnetischen Schicht Probleme aufwirft. Mit anderen Worten, die Erzeugung von lokalen stärkeren Magnetfeldern mittels einer integrierbaren Spule wäre hier von großem Nutzen, zumal über die Windungszahl der Spule die Stärke des Magnetfeldes auf die gewünschte Höhe gebracht werden könnte.

Es ist daher Aufgabe der vorliegenden Erfindung, eine monolithisch integrierbare Induktivität zu schaffen, die insbesondere in einer MRAM-Anordnung vorteilhaft eingesetzt werden kann.

Diese Aufgabe wird erfindungsgemäß durch eine monolithisch integrierbare Induktivität mit den Merkmalen des Patentanspruches 1 gelöst.

Vorteilhafte Weiterbildungen der Erfindung ergeben sich aus den Unteransprüchen.

Die vorliegende Erfindung schafft also eine monolithisch integrierbare Induktivität aus mehreren einander jeweils abwechselnden leitfähigen und isolierenden Schichten und aus die leitfähigen Schichten miteinander durch die isolierenden Schichten hindurch verbindenden Kontakten, bei der die leitfähigen und die isolierenden Schichten übereinander gestapelt und die isolierenden Schichten ganzflächig ausgebildet sind, bei der weiterhin in jeder leitfähigen Schicht der Mittenbereich und ein mit diesem zusammenhängender Randbereich durch eine zusätzliche isolierende Schicht ersetzt ist, bei der außerdem die Randbereiche in aufeinanderfolgenden leitenden Schichten gegeneinander versetzt sind und bei der schließlich die Kontakte zwischen aufeinanderfolgenden Schichten jeweils zwischen diesen in Gebieten nahe bei den Randbereichen gelegen sind.

Die erfindungsgemäße monolithisch integrierbare Induktivität bildet so mit einer Schichtenfolge aus den leitfähigen und isolierenden Schichten eine Spule, deren Flächenbelegung durch "9F" gegeben ist, wobei F die minimale Strukturgröße definiert. Eine solche Schichtenfolge ist ohne weiteres beispielsweise in üblicher CMOS-Technologie realisierbar, indem isolierende Schichten aus z.B. Siliziumdioxid und leitfähige Schichten aus z.B. polykristallinem Silizium übereinandergestapelt werden, wobei für die Kontakte z.B. Aluminium verwendet wird.

Eine MRAM-Zelle kann gebildet werden, indem im Mittenbereich ein Trench (Graben) vorgesehen wird, in welchen ein Schichtstapel aus einer hartmagnetischen Schicht, einer Tunnelbarrierenschicht und einer weichmagnetischen Schicht eingebracht ist. Dieser Schichtstapel ist durch den verbleibenden Rand der den Mittenbereich bildenden zusätzlichen isolierenden Schicht von der Schichtenfolge aus den isolierenden Schichten und leitfähigen Schichten elektrisch getrennt und von dieser, eine Spule bildenden Schichtenfolge umgeben, so daß in dem Schichtstapel ein ausreichend starkes Magnetfeld herrscht, wenn an die Spule aus der Schichtenfolge ein entsprechendes Signal mit einer Stromstärke im mA-Bereich angelegt wird.

Eine besonders wirksame Spule wird erhalten, wenn die Randbereiche in den aufeinanderfolgenden leitfähigen Schichten so zueinander versetzt sind, daß die über die Kontakte miteinander verbundenen leitfähigen Schichten eine spulenförmige Struktur bilden. Die Randbereiche können dabei um einen regelmäßigen Winkel im oder entgegen dem Uhrzeigersinn gegeneinander versetzt sein. Der Winkel kann etwa 90° betragen, wenn insgesamt vier leitfähige Schichten vorgesehen sind, die durch drei zwischenliegende isolierende Schichten voneinander getrennt werden.

Der Schichtstapel im Trench wird auch als GMR (Giant Magnetic Resistance) bezeichnet. Die vertikale Anordnung des GMR im Trench erlaubt die Verwendung von Zellen, die einige µm lang sind und gleichzeitig einen minimalen Flächenbedarf haben.

Der Trench kann in den Mittenbereich der Schichtenfolge ohne weiteres beispielsweise durch Tiefätzen ("Deep-Trench-Ätzung") eingebracht werden, bei dem z.B. das Siliziumdioxid der zusätzlichen isolierenden Schichten in diesem Mittenbereich und der diese trennenden isolierenden Schichten abgetragen wird.

Nachfolgend wird die Erfindung anhand der Zeichnungen näher erläutert. Es zeigen:
- Fig. 1: eine schematische Schnittdarstellung einer Schichtenfolge aus leitfähigen und isolierenden Schichten,
- Fig. 2a bis 2g: Aufsichten auf einzelne leitfähige Schichten (Fig. 2a bis 2d) und isolierende Schichten (Fig. 2e bis 2g) der Schichtenfolge, wobei zur Verdeutlichung der Darstellung die isolierenden Schichten jeweils schraffiert gezeigt sind,
- Fig. 3a und 3b: Schnittdarstellungen einer Schichtenfolge mit einem zusätzlichen GMR-Schichtstapel in zwei Magnetisierungszuständen, nämlich einer parallelen Magnetisierung (Fig. 3a) und einer antiparallelen Magnetisierung (Fig. 3b) und
- Fig. 4a und 4b: schematische Darstellungen von GMR-Schichtstapeln zur Verdeutlichung von zwei logischen Zuständen, nämlich "EIN" (Fig. 4a) und "AUS" (Fig. 4b).

Fig. zeigt eine Schichtenfolge aus leitfähigen Schichten P1, P2, P3 und P4 und isolierenden Schichten I1, I2 und I3, die sich jeweils zwischen den leitfähigen Schichten befinden, so daß beispielsweise die isolierende Schicht I1 zwischen den leitfähigen Schichten P1 und P2, die isolierende Schicht I2 zwischen den leitfähigen Schichten P2 und P3 und die isolierende Schicht I3 zwischen den leitfähigen Schichten P3 und P4 liegen. Für die isolierenden Schichten kann beispielsweise Siliziumdioxid verwendet werden, während ein geeignetes Material für die leitfähigen Schichten polykristallines Silizium ist, das dotiert sein kann. Selbstverständlich können auch andere Materialien gewählt werden, wie beispielsweise Aluminium für die leitfähigen Schichten und Siliziumnitrid für die isolierenden Schichten.

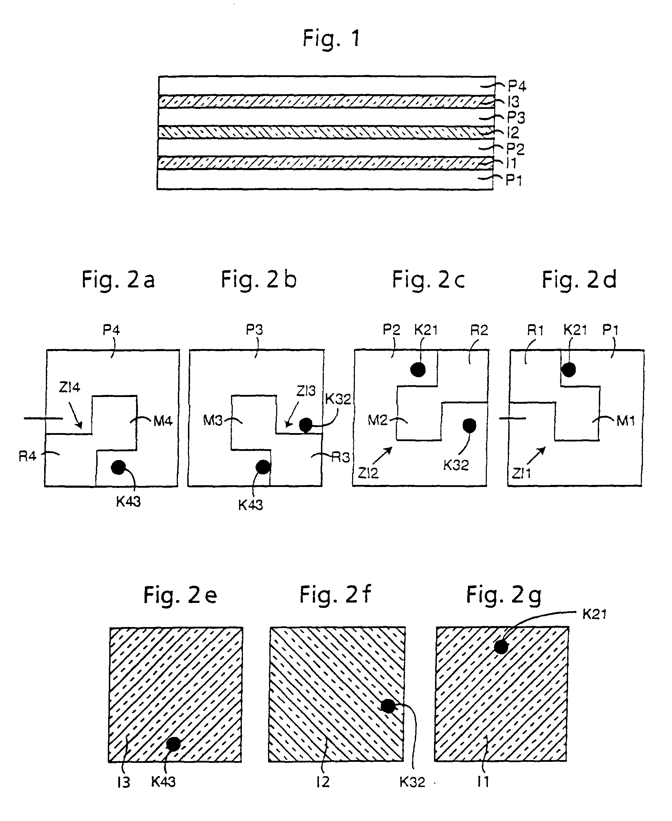

In den Fig. 2a bis 2g sind jeweils in Draufsicht die leitfähigen Schichten P4 (Fig. 2a), P3 (Fig. 2b), P2 (Fig. 2c) und P1 (Fig. 2d) sowie die isolierenden Schichten I3 (Fig. 2e), I2 (Fig. 2f) und I1 (Fig. 2g) gezeigt. Die leitfähigen Schichten enthalten zusätzliche isolierende Schichten ZI4 für die leitfähige Schicht P4, ZI3 für die leitfähige Schicht P3, ZI2 für die leitfähige Schicht P2 und ZI1 für die leitfähige Schicht P1. Diese zusätzlichen isolierenden Schichten ZI1, ZI2, ZI3 und ZI4 bestehen jeweils aus einem Mittenteil M1 bis M4 und einem Randteil R1 bis R4. Es sei angemerkt, daß in Fig. 1 zur Vereinfachung der Darstellung diese zusätzlichen isolierenden Schichten ZI1 bis ZI4 nicht angedeutet sind. Gleiches gilt auch für Kontakte K43, K32 und K21, welche jeweils die leitfähigen Schichten P4 und P3, die leitfähigen Schichten P3 und P2 und die leitfähigen Schichten P2 und P1 über entsprechende Löcher in den isolierenden Schichten I3 und I2 bzw. I1 miteinander verbinden.

Wie aus den Fig. 2a bis 2d zu ersehen ist, befindet sich der Mittenteil M1 bis M4 der zusätzlichen isolierenden Schichten ZI1 bis ZI4 in der Schichtenfolge jeweils an gleicher Stelle, so daß im Mittenbereich dieser Schichtenfolge über die zwischenliegenden isolierenden Schichten I1 bis I3 ein durchgehendes isolierendes Gebiet besteht. Die Randbereiche R1 bis R4 der einzelnen zusätzlichen isolierenden Schichten ZI1 bis ZI4 sind dagegen zyklisch versetzt zueinander so angeordnet, daß insgesamt in der Schichtenfolge eine spulenförmige Struktur durch die leitfähigen Schichten P1 bis P4 gebildet wird. Das heißt, die Randbereiche R1 bis R4 sind versetzt zueinander angeordnet, wobei benachbarte Randbereiche unter einem Winkel von hier 90° zueinander bezüglich der Mittenbereiche M1 bis M4 liegen. Dieser Winkel beträgt vorzugsweise 360°/n, wobei n die Anzahl der leitfähigen Schichten und damit der "Windungen" der Spule bedeutet.

Die anhand der Fig. 1 und 2a bis 2g erläuterte Induktivität besteht so insgesamt aus vier leitfähigen Schichten P1 bis P4 und drei zwischenliegenden isolierenden Schichten I1 bis I3 sowie den zusätzlichen isolierenden Schichten ZI1 bis ZI4. Selbstverständlich können auch mehr oder weniger leitfähige Schichten, isolierende Schichten und entsprechende zusätzliche isolierende Schichten vorgesehen werden. Wesentlich ist aber, daß die leitfähigen Schichten P1 bis P4 über die sie verbindenden Kontakte K21, K32 und K43 insgesamt eine spulenförmige Struktur bilden, die eine Spule darstellt, welche im Mittenbereich ein relativ starkes Magnetfeld erzeugt.

Die leitfähigen Schichten P1 bis P4 und die isolierenden Schichten I1 bis I3 können ohne weiteres beispielsweise durch Aufdampfen gebildet werden. Gleiches gilt auch für die zusätzlichen isolierenden Schichten ZI1 bis ZI4, die durch Ätzen strukturiert werden können. Auch die leitfähigen Schichten P1 bis P4 können durch Ätzen mit der die Spule bildenden Gestalt versehen werden. Selbstverständlich sind aber auch andere Technologien zur Herstellung dieser Schichten der Schichtenfolge möglich und anwendbar.

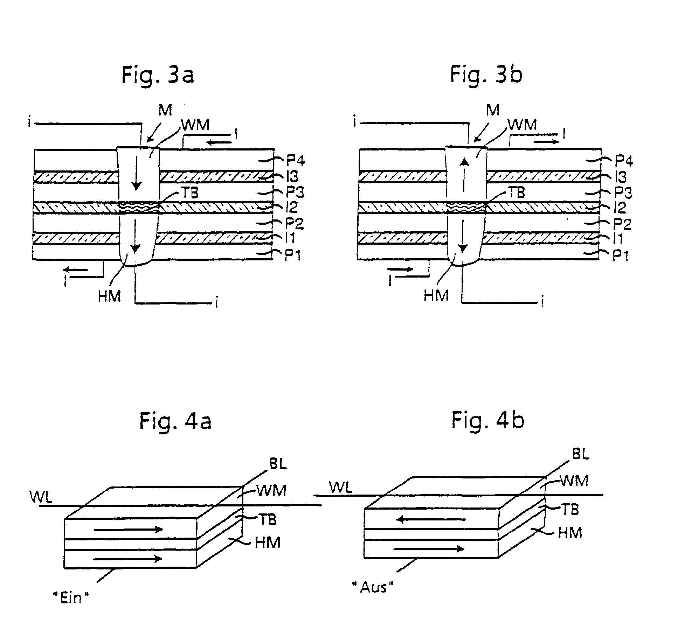

Die Fig. 3a und 3b zeigen die Schichtenfolge von Fig. 1, wobei hier im Mittenbereich M ein Schichtstapel aus einer hartmagnetischen Schicht HM, einer Tunnelbarrierenschicht TB und einer weichmagnetischen Schicht WM gelegen ist. Hierzu sind die Mittenbereiche M1 bis M4 der zusätzlichen isolierenden Schichten ZI1 bis ZI4 und der zwischenliegenden isolierenden Schichten I1 bis I3 so durch beispielsweise Ätzen abgetragen, daß ein isolierender Rand zurückbleibt, der die weichmagnetische Schicht WM, die Tunnelbarrierenschicht TB und die hartmagnetische Schicht HM elektrisch von den leitfähigen Schichten P1 bis P4 isoliert.

Durch die aus den leitfähigen Schichten P1 bis P4 fließt ein Strom I, der im Mittenbereich M ein Magnetfeld erzeugt. Dieses Magnetfeld stellt die Magnetisierungsrichtung der weichmagnetischen Schicht WM ein, so daß diese abhängig von der Stromrichtung des Stromes I parallel zu der Magnetisierungsrichtung der hartmagnetischen Schicht HM, wie in Fig. 3a gezeigt ist, oder antiparallel zu dieser ist, wie dies aus der Fig. 3b hervorgeht. Der parallelen Magnetisierung der Schichten WM und HM ist ein niedriger elektrischer Widerstandswert des Schichtstapels aus den Schichten WM, TB und HM zugeordnet, während die antiparallele Magnetisierung zu einem höheren Widerstandswert dieses Schichtstapels führt. Dieser Widerstandswert kann durch einen durch den Schichtstapel fließenden Strom i gemessen und ausgewertet werden.

Die Fig. 4a und 4b verdeutlichen nochmals den Schichtstapel aus der hartmagnetischen Schicht HM, der Tunnelbarrierenschicht TB und der weichmagnetischen Schicht WM, wobei hier allerdings dieser Schichtstapel in einer bestehenden MRAM-Anordnung zwischen einer Wortleitung WL und einer Bitleitung BL liegt und über diese eingeschrieben und ausgelesen wird.

Wird die Schichtenfolge der Fig. 3a und 3b in einer bestehenden MRAM-Anordnung verwendet, so wird beispielsweise der Strom I über die Wortleitung WL und die Bitleitung BL in die Zelle eingeschrieben, während der Lesestrom i über eine zusätzliche Leitung, die parallel zur Wortleitung WL oder parallel zur Bitleitung BL sein kann, abgeführt wird.

Ein wesentlicher Vorteil der erfindungsgemäßen monolithisch integrierbaren Induktivität liegt auch darin, daß die Schichtenfolge aus den leitfähigen Schichten P1 bis P4 und den isolierenden Schichten I1 bis I3 ohne weiteres auf einem Halbleiterkörper vorgesehen werden kann. Es ist dann möglich, in diesen Halbleiterkörper für die einzelnen Speicherzellen Transistoren einzubetten, so daß die einzelnen Speicherzellen jeweils mit einem Schalttransistor versehen werden können.

## Patentansprüche

1. Monolithisch integrierte Induktivität aus mehreren einander jeweils abwechselnden leitfähigen (P1 bis P4) und isolierenden (I1 bis I3) Schichten und aus die leitfähigen Schichten (P1 bis P4) miteinander durch die isolierenden Schichten (I1 bis I3) hindurch verbindenden Kontakten (K21, K32, K43),
- bei der die leitfähigen (P1 bis P4) und die isolierenden (I1 bis I3) Schichten übereinander gestapelt und die isolierenden Schichten (I1 bis I3) ganzflächig ausgebildet sind,
- bei der weiterhin in jeder leitfähigen Schicht (P1 bis P3) der Mittenbereich (M1 bis M4) und ein mit diesem zusammenhängender Randbereich (R1 bis R4) durch eine zusätzliche isolierende Schicht ersetzt sind,
- bei der die Randbereiche (R1 bis R4) in aufeinanderfolgenden leitfähigen Schichten (P1 bis P4) gegeneinander versetzt sind und
- bei der die Kontakte (K21, K32, K43) zwischen aufeinander folgenden leitfähigen Schichten (P1 bis P4) jeweils zwischen diesen in Gebieten nahe bei den Randbereichen (R1 bis R4) gelegen sind,
**dadurch gekennzeichnet, daß**
im Mittenbereich (M) ein Trench vorgesehen ist, der mit GMR-Materialien (WM, TB, HM) gefüllt ist, die eine MRAM-Zelle bilden.

2. Monolithisch integrierte Induktivität nach Anspruch 1,
**dadurch gekennzeichnet, daß**
die GMR-Materialien aus einem Schichtstapel aus einer hartmagnetischen Schicht (HM), einer Tunnelbarrierenschicht (TB) und einer weichmagnetischen Schicht (WM) bestehen.

3. Monolithisch integrierte Induktivität nach Anspruch 1 oder 2,
**dadurch gekennzeichnet, daß**
die Randbereiche (R1 bis R4) in den aufeinanderfolgenden leitfähigen Schichten (P1 bis P4) so zueinander versetzt sind, daß die über die Kontakte (K21, 32, K43) miteinander verbundenen leitfähigen Schichten (P1 bis P4) eine spulenförmige Struktur bilden.

4. Monolithisch integrierte Induktivität nach einem der Ansprüche 1 bis 3,
**dadurch gekennzeichnet, daß**
die Randbereiche (R1 bis R4) um einen regelmäßigen Winkel im oder entgegen dem Uhrzeigersinn gegeneinander versetzt sind.

5. Monolithisch integrierte Induktivität nach einem der Ansprüche 1 bis 4,
**dadurch gekennzeichnet, daß**
der Winkel 90° beträgt.

6. Monolithisch integrierte Induktivität nach einem der Ansprüche 1 bis 5,
**dadurch gekennzeichnet, daß**
die leitfähigen Schichten (P1 bis P4) aus polykristallinem Silizium gebildet sind.

7. Monolithisch integrierte Induktivität nach Anspruch 6,
**dadurch gekennzeichnet, daß**
das polykristalline Silizium dotiert ist.

8. Monolithisch integrierte Induktivität nach einem der Ansprüche 1 bis 7,
**dadurch gekennzeichnet, daß**
die Schichtenfolge aus den leitfähigen Schichten (P1 bis P4) und den isolierenden Schichten (I1 bis I3) auf einem Halbleiterkörper vorgesehen ist.
